# EUROPEAN PATENT APPLICATION

(11) **EP 1 503 501 A1**
(43) Date of publication of application: **02.02.2005**
(21) Application number: 04254284.5
(22) Date of filing: 16.07.2004
(51) Int. Cl.: H03M 5/18

(54) **Duobinary to binary decoder**

(30) Priority: 30.07.2003 US 630422
(71) Applicant: LUCENT TECHNOLOGIES INC., Murray Hill, New Jersey 07974-0636 (US)
(72) Inventor: Adamiecki, Andrew L., Morganville New Jersey 07751 (US); Sinsky, Jeffrey H., Marlbor New Jersey 07746 (US)
(74) Representative: Watts, Christopher Malcolm Kelway, Dr.

(57) **Abstract**

A duobinary-to-binary signal converter includes a pair of comparators coupled to a logic gate. Each comparator receives a copy of a duobinary-encoded analog signal applied to the converter and is designed to generate a binary output based on the comparison of the magnitude of the received signal with a corresponding threshold voltage. The outputs of the comparators are fed into the logic gate, which generates a binary sequence corresponding to the duobinary-encoded signal. A representative converter of the invention can perform relatively well at bit rates as high as about 40 Gb/s and can be conveniently incorporated into an appropriate integrated device (e.g., an ASIC) for a data transmission system employing duobinary signaling.

## Description

### BACKGROUND OF THE INVENTION

### Field of the Invention

The present invention relates to communication equipment and, more specifically, to equipment for decoding duobinary signals.

### Description of the Related Art

Duobinary signaling was introduced in the 1960s and since then has found numerous applications in communication systems. The principle of duobinary signaling is explained, for example, in an article by A. Lender that appeared in IEEE Transactions on Communications and Electronics, Vol. 82 (May, 1963), pp. 214-218, the teachings of which are incorporated herein by reference. Briefly, duobinary signaling uses three signal levels, for example, "+1", "0", and "-1". A signal corresponding to one of these levels (i.e., a duobinary symbol) is transmitted during each signaling interval (time slot). A duobinary signal is typically generated from a corresponding binary signal using certain transformation rules. Although both signals carry the same information, the bandwidth of the duobinary signal may be reduced by a factor of 2 compared to that of the binary signal at the expense of signal-to-noise ratio. In addition, the duobinary signal may be constructed such that it has certain inter-symbol correlation (ISC) data, which can be used to implement an error-correction algorithm at the receiver.

A number of different transformations have been proposed for constructing a duobinary sequence, *b*_{*k*}, from a corresponding binary sequence, *a*_{*k*}, where *k* = 1, 2, 3, ... One such transformation described in the above-cited Lender article is as follows. For any particular *k = m*, when *a*_{*m*} = 0, *b*_{*m*} = 0. When *a*_{*m*} = 1, *b*_{*m*} equals either +1 or -1, with the polarity of *b*_{*m*} determined based on the polarity of last non-zero symbol *b*_{*m-i*} preceding *b*_{*m*}, where *i* is a positive integer. More specifically, when *i* is odd, the polarity of *b*_{*m*} is the same as the polarity of *b*_{*m-i*}; and, when *i* is even, the polarity of *b*_{*m*} is the opposite of the polarity of *b*_{*m-i*}. Due to the properties of this transformation, the duobinary sequence has no transitions between the "+1" and "-1" levels in successive time slots. Only transitions between (i) "0" and "+1" and (ii) "0" and "-1" levels can occur. Reconstruction of *a*_{*k*} from a known *b*_{*k*} is relatively straightforward. More specifically, when *b*_{*m*} = ±1, *a*_{*m*} = 1; and, when *b*_{*m*} = 0, *a*_{*m*} = 0.

Table 1 reproduces an example given in the Lender article to further illustrate the above-described transformation.

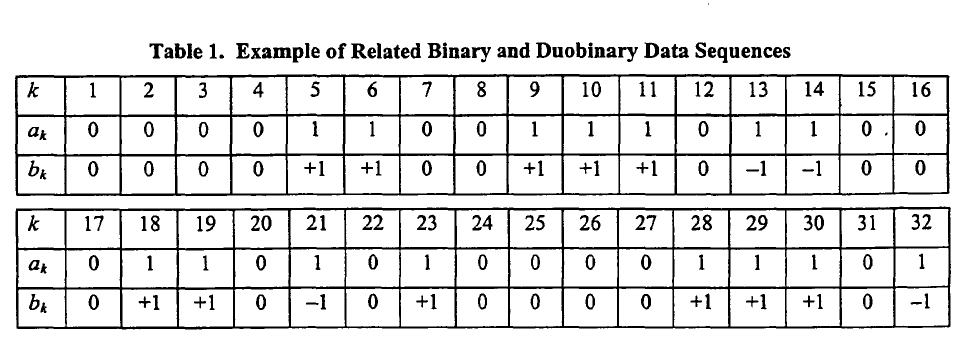

A duobinary-to-binary (D/B) signal converter is a device that is used at the receiver end of a data transmission system to reconstruct a binary sequence from a corresponding duobinary-encoded signal. A typical prior-art D/B converter is implemented using a full-wave rectifier as described in more detail below. However, one problem with such a converter is that, at relatively high data transmission rates, e.g., when the physical size of the circuit is comparable to the wavelength corresponding to the data rate, its performance becomes adversely affected. For the current level of technology, such a problem occurs at data rates of about 10 Gb/s.

### SUMMARY OF THE INVENTION

Problems in the prior art are addressed, in accordance with the principles of the present invention, by a duobinary-to-binary signal converter including, in one embodiment, a pair of comparators coupled to a logic gate. Each comparator receives a copy of a duobinary-encoded analog signal applied to the converter and is designed to generate a binary output based on the comparison of the magnitude of the received signal with a corresponding threshold voltage. The outputs of the comparators are fed into the logic gate, which generates a binary sequence corresponding to the duobinary-encoded signal. A representative converter of the invention can perform relatively well at bit rates as high as about 40 Gb/s and can be conveniently incorporated into an appropriate integrated device (e.g., an ASIC) for a data transmission system employing duobinary signaling.

According to one embodiment, the present invention is a device, comprising: a first comparator adapted to receive a first copy of an input signal and generate a first binary signal; a second comparator adapted to receive a second copy of the input signal and generate a second binary signal; and a logic gate adapted to generate a third binary signal based on the first and second binary signals, wherein: the input signal corresponds to a duobinary sequence; and the third binary signal is a binary representation of the duobinary sequence.

According to another embodiment, the present invention is a method of signal processing, comprising: (A) comparing magnitude of an electrical signal with first and second threshold voltages to generate first and second binary values; (B) applying a logic function to the first and second binary values to generate a third binary value; and (C) repeating steps (A) and (B) to generate a sequence of third binary values, wherein: the electrical signal corresponds to a duobinary sequence; and the sequence of third values is a binary representation of the duobinary sequence.

According to yet another embodiment, the present invention is a data transmission system designed to use duobinary signaling, the system including a device comprising: a first comparator adapted to receive a first copy of an input signal and generate a first binary signal; a second comparator adapted to receive a second copy of the input signal and generate a second binary signal; and a logic gate adapted to generate a third binary signal based on the first and second binary signals, wherein: the input signal corresponds to a duobinary sequence; and the third binary signal is a binary representation of the duobinary sequence.

### BRIEF DESCRIPTION OF THE DRAWINGS

Other aspects, features, and benefits of the present invention will become more fully apparent from the following detailed description, the appended claims, and the accompanying drawings in which:
Fig. 1 shows a block diagram of a representative data transmission system employing duobinary signaling;
Fig. 2 shows a block diagram of a representative prior-art D/B converter that can be used in the system of Fig. 1;
Fig. 3 shows a block diagram of a D/B converter that can be used in the system of Fig. 1 according to one embodiment of the present invention;
Fig. 4 graphically illustrates one exemplary configuration of the D/B converter of Fig. 3; and
Fig. 5 shows a block diagram of a D/B converter that can be used in the system of Fig. 1 according to another embodiment of the present invention.

### DETAILED DESCRIPTION

Reference herein to "one embodiment" or "an embodiment" means that a particular feature, structure, or characteristic described in connection with the embodiment can be included in at least one embodiment of the invention. The appearances of the phrase "in one embodiment" in various places in the specification are not necessarily all referring to the same embodiment, nor are separate or alternative embodiments mutually exclusive of other embodiments.

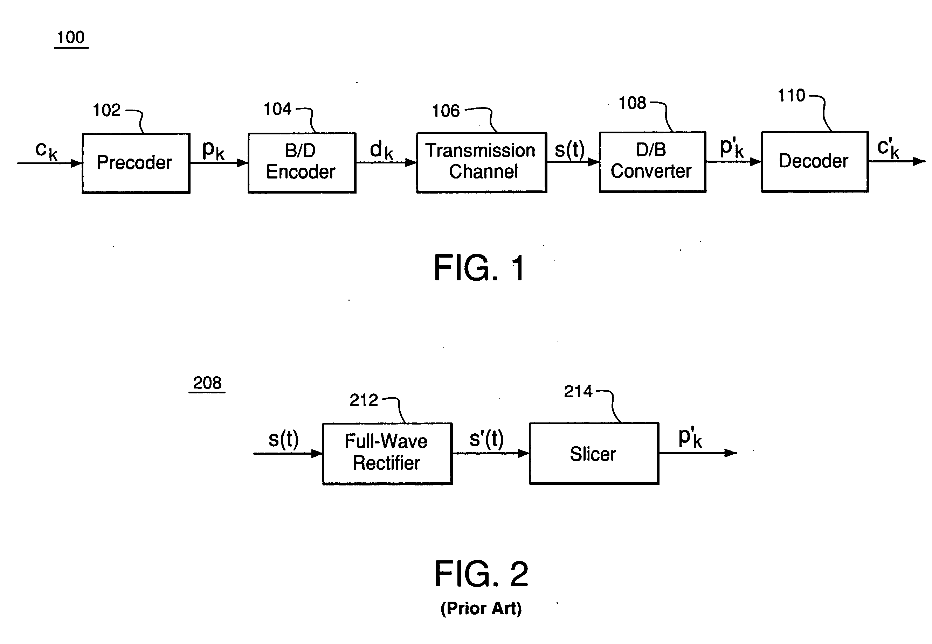

Fig. 1 shows a block diagram of a representative data transmission system **100** employing duobinary signaling. More specifically, system **100** is designed to transmit information corresponding to an input binary data sequence, *c*_{*k*}, e.g., a pseudo-random bit stream (PRBS), over a transmission channel **106.** Sequence *c*_{*k*} is recovered at the output of system **100** as sequence *c'*_{*k*}. At the transmitter end, system **100** has a precoder **102** designed to introduce inter-symbol correlation (ISC) data into sequence *c*_{*k*}. The resulting correlated binary sequence, *p*_{*k*}, is applied to a binary-to-duobinary (B/D) encoder **104,** which generates a corresponding duobinary sequence, *d*_{*k*}. More details on representative circuits that can serve as precoder **102** and encoder **104** in system **100** can be found, for example, in U.S. Patent No. 5,892,858, the teachings of which are incorporated herein by reference.

Transmission channel 106 has a transmitter coupled to one end of a transmission link and an optional receiver coupled to the other end of that transmission link (none of which are explicitly shown in Fig. 1). Based on duobinary sequence *d*_{*k*}, the transmitter generates an appropriate communication signal and applies that signal to the transmission link. At the remote end of the link, the receiver (if any) receives the communication signal and generates a corresponding analog signal denoted as *s(t)* in Fig. 1. In one embodiment, channel 106 has (i) a transmitter comprising a laser coupled to an electro-optical modulator and (ii) a receiver comprising a photodiode, said transmitter and receiver coupled to an optical fiber. In another embodiment, channel **106** has a radio-frequency (RF) transmitter and an RF receiver communicating over the wireless medium. In yet another embodiment, channel 106 has an electrical waveform generator coupled to a conductor, e.g., a micro-strip line on a circuit board.

Signal *s(t)* outputted by transmission channel 106 is applied to a D/B converter **108** to generate binary sequence *p'*_{*k*}, which, with the exception of possible errors mostly due to imperfections in transmission channel **106,** is identical to sequence *p*_{*k*}. A decoder **110** reverses the coding of precoder **102** to generate sequence *c'*_{*k*}. Decoder **110** may be designed to utilize the ISC of sequence *p*_{*k*} to detect and correct errors in sequence *p'*_{*k*}. A representative implementation of decoder **110** is described in U.S. Patent No. 4,086,566, the teachings of which are incorporated herein by reference.

Fig. 2 shows a block diagram of a representative prior-art D/B converter **208,** which can be used as D/B converter **108** in system **100.** Converter **208** includes a full-wave rectifier (FWR) **212** coupled to a slicer **214.** FWR **212** converts signal *s(t)* into rectified signal *s'(t)*, in which polarity of the negative waveforms is reversed while the positive waveforms remain substantially unchanged. Exemplary embodiments of FWR **212** can be found in U.S. Patent Nos. 4,941,080 and 6,480,405, the teachings of both of which are incorporated herein by reference. Slicer **214** then processes signal *s'(t)* as known in the art to produce sequence *p'*_{*k*}.

Although converter **208** is easily adapted to work at relatively low frequencies/bit rates, the same is not true for relatively high bit rates, e.g., about 10 Gb/s. In particular, when the wavelength of RF signals in FWR **212** is comparable to certain circuit dimensions, parasitic circuit effects adversely affect the performance of the FWR and thereby converter **208.** As a result, designing converter **208** that works well at relatively high bit rates and is also relatively small, power-efficient, and inexpensive may be difficult.

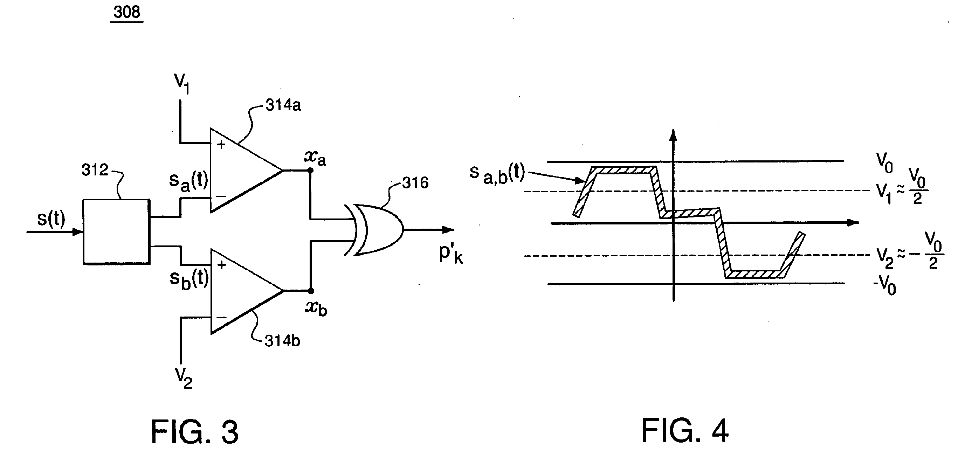

Fig. 3 shows a block diagram of a D/B converter **308,** which can be used as D/B converter **108** in system **100** according to one embodiment of the present invention. As will be understood by one skilled in the art from the provided description, converter **308** performs relatively well at or above about 10 Gb/s and, at the same time, unlike prior-art converter **208**, may be smaller and less expensive to implement. In addition, converter **308** can be adapted in a relatively straightforward fashion to work at even higher bit rates and lends itself to relatively easy incorporation into an integrated device (e.g., an ASIC) for system **100.**

Signal *s(t)* applied to converter **308** is divided into two signal copies, *s*_{*a*}*(t)* and *s*_{*b*}*(t)*, using a wideband splitter **312** preferably having a bandwidth of about 1/2T_{b}, where T_{b} is the bit period of sequence *c*_{*k*}. Copy *s*_{*a*}*(t)* is applied to an inverting input of a first comparator **314a,** whose non-inverting input receives a first threshold voltage, V₁. Similarly, copy *s*_{*b*}*(t)* is applied to a non-inverting input of a second comparator **314b,** whose inverting input receives a second threshold voltage, V₂. The output, *x*, of each comparator **314** is a digital signal generated as follows. When V₋ ≥ V₊, *x* = 0; and, when V₋ < V₊, *x* = 1, where V₋ and V₊ are the voltages applied to the inverting and non-inverting inputs, respectively, of the comparator. The output of each comparator **314** is applied to an exclusive-OR (XOR) gate **316,** which generates sequence *p'*_{*k*}. Each of comparator **314a,** comparator **314b,** and XOR gate **316** preferably has a bandwidth of about 1/T_{b}.

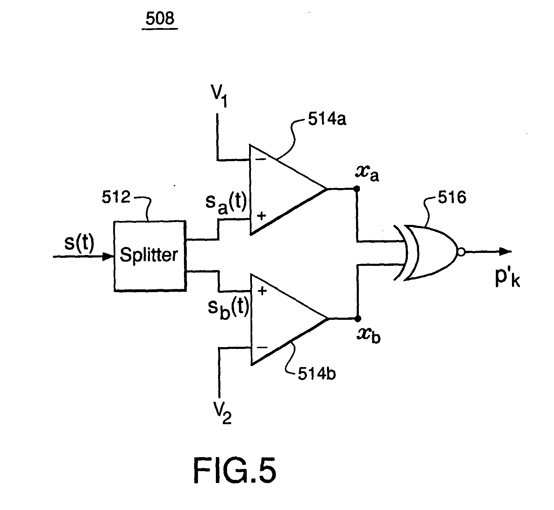

Fig. 4 graphically illustrates one exemplary configuration of converter **308.** More specifically, threshold voltages V₁ and V₂ are set at the values of about V₀/2 and -V₀/2, where V₀ is a voltage corresponding to the duobinary signal levels in signal copies *s*_{*a*}*(t)* and *s*_{*b*}*(t)*. The signal trace shown in Fig. 4 corresponds to a duobinary sequence of "+1, 0, -1".

Table 2 illustrates the operation of converter **308** configured in accordance with Fig. 4.

**Table 2.**

| **Exemplary Signal Values Generated in the Converter of Fig. 3** | | | |
|---|---|---|---|
| *s*_{*a,b*}*(t)* | *x*_{*a*} | *x*_{*b*} | *p'*_{*k*} |
| *s*_{*a,b*}*(t)* ≥ V₀/2 | 0 | 1 | 1 |
| -V₀/2 ≤ *s*_{*a,b*}*(t)* < V₀/2 | 1 | 1 | 0 |
| *s*_{*a,b*}*(t)* < -V₀/2 | 1 | 0 | 1 |

As indicated in Table 2, so configured converter **308** will correctly convert the signal shown in Fig. 4 into a binary sequence of "101".

Fig. 5 shows a block diagram of a D/B converter **508,** which can be used as D/B converter **108** in system **100** according to another embodiment of the present invention. Converter **508** is similar to converter **308** (Fig. 3) and includes a wideband splitter **512,** two comparators **514a-b,** and a logic gate **516**. However, one difference between converters **508** and **308**, is that, in converter **508**, each signal copy is applied to a non-inverting input of the corresponding comparator **514**. Another difference between said converters is that logic gate **516** is an exclusive-NOR (XNOR) gate.

Table 3 illustrates the operation of converter **508** configured in accordance with Fig. 4.

**Table 3.**

| **Exemplary Signal Values Generated in the Converter of Fig. 5** | | | |
|---|---|---|---|
| *s*_{*a,b*}*(t)* | *x*_{*a*} | *x*_{*b*} | *p'*_{*k*} |
| *s*_{*a,b*}*(t)* > V₀/2 | 1 | 1 | 1 |
| - V₀/2 ≤ *s*_{*a,b*}*(t)* ≤ V₀/2 | 0 | 1 | 0 |
| *s*_{*a,b*}*(t)* < -V₀/2 | 0 | 0 | 1 |

As indicated in Table 3, similar to converter **308**, converter **508** will correctly convert the signal shown in Fig. 4 to generate the "101" sequence.

Advantageously, converters of the present invention adapted for relatively high bit rates do not require complex microwave-matching circuits of prior-art converters (e.g., converter **208** of Fig. 2). Furthermore, the inventors' own research demonstrated that a converter of the invention embodied in an indium-phosphate-based integrated circuit (i) was robust and relatively inexpensive and (ii) performed relatively well with bit rates as high as 40 Gb/s.

While this invention has been described with reference to illustrative embodiments, this description is not intended to be construed in a limiting sense. Although converters of the present invention are described as receiving analog signals, they can similarly be configured to receive digital signals. Data sequences may be represented by non-return-to-zero (NRZ) or return-to-zero (RZ) signals. A converter of the invention may be based on a pair of comparators whose configuration may be differently and appropriately selected. A logic gate may be implemented as a combination of suitable logic elements as known in the art. For example, XNOR gate **516** (Fig. 5) may be implemented as an XOR gate followed by an inverter. Transmission system employing a converter of the invention may be configured to operate with or without data precoding and the corresponding decoding. Although exemplary data rates (e.g., 10 Gb/s) were used in the above description, converters of the invention may similarly be designed to operate at other selected bit rates. Various modifications of the described embodiments, as well as other embodiments of the invention, which are apparent to persons skilled in the art to which the invention pertains are deemed to lie within the principle and scope of the invention as expressed in the following claims.

Although the steps in the following method claims, if any, are recited in a particular sequence with corresponding labeling, unless the claim recitations otherwise imply a particular sequence for implementing some or all of those steps, those steps are not necessarily intended to be limited to being implemented in that particular sequence.

## Claims

1. A device, comprising:
a first comparator adapted to receive a first copy of an input signal and generate a first binary signal;
a second comparator adapted to receive a second copy of the input signal and generate a second binary signal; and
a logic gate adapted to generate a third binary signal based on the first and second binary signals, wherein:
the input signal corresponds to a duobinary sequence; and
the third binary signal is a binary representation of the duobinary sequence.

2. The device of claim 1, wherein:
the input signal is an analog signal;
the logic gate comprises an exclusive-OR gate; and
the input signal corresponds to a bit rate of higher than about 10 Gb/s.

3. The device of claim 1, further comprising a splitter adapted to receive the input signal and generate the first and second copies, wherein:
the splitter has a bandwidth of about 1/2T_{b}, where T_{b} is a bit period corresponding to the input signal; and
each of the first and second comparators and the logic gate has a bandwidth of about 1/T_{b}.

4. The device of claim 1, wherein:
for each comparator,
when voltage applied to a first input port is equal to or higher than voltage applied to a second input port, the corresponding binary signal has binary "0"; and
when the voltage applied to the first input port is lower than the voltage applied to the second input port, the corresponding binary signal has binary "1".

5. The device of claim 4, wherein:
for the first comparator,
the first copy is applied to the first input port; and
a first threshold voltage is applied to the second input port; and
for the second comparator,
a second threshold voltage is applied to the first input port; and
the second copy is applied to the second input port.

6. The device of claim 4, wherein:
for each comparator,
a corresponding threshold voltage is applied to the first input port; and
the corresponding signal copy is applied to the second input port.

7. A method of signal processing, comprising:
(A) comparing magnitude of an electrical signal with first and second threshold voltages to generate first and second binary values;
(B) applying a logic function to the first and second binary values to generate a third binary value; and
(C) repeating steps (A) and (B) to generate a sequence of third binary values, wherein:
the electrical signal corresponds to a duobinary sequence; and
the sequence of third values is a binary representation of the duobinary sequence.

8. The method of claim 7, wherein, for step (A):
for each threshold voltage,
when the magnitude of the electrical signal is equal to or higher than the threshold voltage, the corresponding binary value is "0"; and
when the magnitude of the electrical signal is lower than the threshold voltage, the corresponding binary value is "1".

9. The method of claim 7, wherein, for step (A):
when the magnitude of the electrical signal is equal to or higher than the first threshold voltage, the first binary value is "0";
when the magnitude of the electrical signal is lower than the first threshold voltage, the first binary value is "1";
when the magnitude of the electrical signal is equal to or lower than the second threshold voltage, the second binary value is "0"; and
when the magnitude of the electrical signal is higher than the second threshold voltage, the second binary value is "1".

10. A data transmission system designed to use duobinary signaling, the system including a device comprising:
a first comparator adapted to receive a first copy of an input signal and generate a first binary signal;
a second comparator adapted to receive a second copy of the input signal and generate a second binary signal; and
a logic gate adapted to generate a third binary signal based on the first and second binary signals, wherein:
the input signal corresponds to a duobinary sequence; and
the third binary signal is a binary representation of the duobinary sequence.
